# FASCICULE DE BREVET EUROPEEN

(11) **EP 3 660 928 B1**
(45) Date de publication et mention de la délivrance du brevet: **15.09.2021**
(21) Numéro de dépôt: 19210356.2
(22) Date de dépôt: 20.11.2019
(51) Int. Cl.: H01L 31/068, H01L 31/18

(54) **PROCÉDÉ DE FABRICATION DE CELLULES PHOTOVOLTAIQUES**
HERSTELLUNGSVERFAHREN VON FOTOVOLTAIK-SOLARZELLEN
METHOD FOR MANUFACTURING PHOTOVOLTAIC CELLS

(30) Priorité: 27.11.2018 FR 1871923
(43) Date de publication de la demande: 03.06.2020
(73) Titulaire: Commissariat à l'énergie atomique et aux énergies alternatives, 75015 Paris (FR)
(72) Inventeur: LANTERNE, Adeline, 38054 GRENOBLE CEDEX 09 (FR)
(74) Mandataire: Brevalex

(56) Documents cités:
- EP-A2- 2 608 280
- ADELINE LANTERNE ET AL: "Implanted selective emitter solar cells by laser thermal annealing", AIP CONFERENCE PROCEEDINGS, 1 janvier 2012 (2012-01-01), pages 131-134, XP055595470, NEW YORK, US ISSN: 0094-243X, DOI: 10.1063/1.4766507
- HALLAM BRETT ET AL: "Efficiency enhancement of i-PERC solar cells by implementation of a laser doped selective emitter", SOLAR ENERGY MATERIALS AND SOLAR CELLS, vol. 134, 5 décembre 2014 (2014-12-05), pages 89-98, XP029134946, ISSN: 0927-0248, DOI: 10.1016/J.SOLMAT.2014.11.028

## Description

### DOMAINE TECHNIQUE ET ÉTAT DE LA TECHNIQUE ANTÉRIEURE

La présente invention a trait au domaine des structures semiconductrices dopées notamment dans le photovoltaïque, et plus particulièrement à celui de structures comportant des zones adjacentes dopées N et ayant des concentrations en dopants et/ou profils de dopage différents.

Dans une cellule solaire il est courant de réaliser, sur une même face, des zones dopées avec des résistances carrées respectives différentes.

Le document « Efficiency enhancement of i-PERC solar cells by implementation of a laser doped selective emitter» Hallam, Solar Energy Materials&SolarCells 134(2015)89-98, présente par exemple une cellule solaire dont la face avant texturée comporte des premières zones fortement dopées N++ permettant de réaliser un contact ohmique avec une électrode sous forme de pistes métalliques, et des secondes zones dopées N+, destinées à former la zone sensible exposée au rayonnement solaire et dont le dopage est plus faible notamment afin d'éviter les recombinaisons électrons-trous par recombinaisons Auger.

Différentes techniques de dopage existent pour la réalisation des cellules solaires. À part la diffusion gazeuse à haute température traditionnellement utilisée pour son faible coût, le dopage par implantation ionique associé à un recuit thermique présente l'avantage d'être plus uniforme et est très reproductible. Il permet de plus un dopage « simple face » qui peut simplifier les procédés de fabrication, ainsi qu'une plus grande flexibilité sur les profils de concentration en dopants obtenus.

Pour réaliser des zones dopées avec des profils de concentration en dopants différents, une méthode consiste à réaliser plusieurs implantations. Pour au moins une de ces implantations, on utilise un masque avec une ou plusieurs ouvertures à travers lesquelles on réalise un dopage des zones auxquelles on souhaite conférer la concentration en dopants la plus forte. Le masque permet alors de protéger les zones adjacentes prévues avec une concentration en dopants plus faible.

Une autre méthode décrite dans le document EP2 608 280 A2 et permettant de se passer d'une technique de masquage et de n'utiliser qu'une seule étape d'implantation, consiste à utiliser des recuits différents pour réaliser des zones dopées N+ et N++ sur une même face et en particulier d'effectuer un recuit laser d'activation localisé afin d'activer une plus grande dose de dopants dans la zone dopée N++, cette dernière s'étendant également davantage en profondeur. Un tel recuit laser d'activation peut avoir tendance à dégrader la face exposée au laser, et en particulier lorsque cette face comporte une zone texturée de fondre et dégrader la texturation. Le document "Implanted selective emitter solar cells by laser thermal annealing", Adeline LANTERNE ET AL, AIP CONFERENCE PROCEEDINGS, 1496, pages 131-134 (2012) divulgue un procédé de réalisation d'une structure semi-conductrice pour cellule solaire avec des régions dopées N ayant des profils et/ou des concentrations en dopants différentes.

Il se pose le problème de trouver un nouveau procédé de réalisation de zones adjacentes dopées ayant des profils et concentrations différentes et qui soit de préférence amélioré vis-à-vis d'inconvénients mentionnés ci-dessus.

### EXPOSE DE L'INVENTION

Selon un aspect, la présente invention concerne un procédé de réalisation d'une structure semi-conductrice pour cellule solaire (également appelée cellule photovoltaïque), avec des régions dopées N ayant des profils et/ou des concentrations en dopants différentes, comprenant :
- implanter une espèce dopante, en particulier du Phosphore, dans une zone superficielle d'un substrat semi-conducteur, typiquement en silicium cristallin,
- effectuer un recuit thermique de recristallisation localisé à une température de préférence inférieure à 700°C d'une ou plusieurs premières régions, le recuit thermique de recristallisation localisé étant réalisé à l'aide d'un laser en exposant lesdites une ou plusieurs premières régions de la zone superficielle tandis que des portions de la zone superficielle ne sont pas exposées au laser, puis
- conserver le substrat pendant un temps d'attente prédéterminé supérieur à 1 h de préférence supérieur à 5h et avantageusement égal ou supérieur à 24h, puis,
- effectuer un recuit d'activation des dopants des premières régions et desdites portions par traitement thermique de l'ensemble des premières régions et desdites portions.

Pendant le temps d'attente, le phosphore dans les portions non exposées au recuit laser de recristallisation a tendance à désorber ou davantage désorber que dans les régions exposées au recuit laser ce qui permet, une fois l'activation des dopants réalisées, d'obtenir des zones dopées de profils et/ou concentrations différentes.

Typiquement, la zone superficielle comporte au moins une face texturée avec des motifs en relief, en particulier des motifs pyramidaux ou formant une surface dentelée. Le recuit laser de recristallisation est réalisé tout en préservant ces motifs ou cette surface dentelée.

De préférence, le substrat est conservé durant ledit temps d'attente sous atmosphère contenant de l'oxygène.

Le recuit d'activation des dopants des premières régions et des dites portions peut être réalisé à une température comprise entre 780°C et 1100°C, de préférence entre 800°C et 950°C.

Avantageusement, l'implantation de ladite espèce dopante est réalisée par immersion plasma (PIII), en particulier à l'aide d'un précurseur gazeux à base de PH₃.

À l'issue dudit recuit d'activation lesdites une ou plusieurs premières régions peuvent être dopées N++, tandis que lesdites une ou plusieurs portions sont dopées N+.

Avantageusement, à l'issue dudit recuit d'activation, la différence de résistance carré desdites une ou plusieurs premières régions et desdites portions est d'au moins 5 ohm/carré.

Un mode de réalisation de l'invention concerne un procédé de réalisation d'une cellule solaire comprenant :
- la mise en œuvre d'une structure suivant un procédé tel que défini plus haut, puis,
- la formation d'un ou plusieurs contacts respectivement sur lesdites une ou plusieurs premières régions.

### BREVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
Les figures 1A-1F servent à illustrer un exemple de procédé de réalisation de zones dopées au phosphore de concentration en dopants et profils différents dans une structure semi-conductrice de cellule solaire ;
La figure 2 sert à illustrer un exemple de protocole pour déterminer une puissance laser utilisée lors d'un recuit de recristallisation mis en œuvre au cours d'un procédé suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », s'appliquent en considérant que la structure est orientée de la façon illustrée sur les figures.

### EXPOSE DETAILLE DE MODES DE REALISATION PARTICULIERS

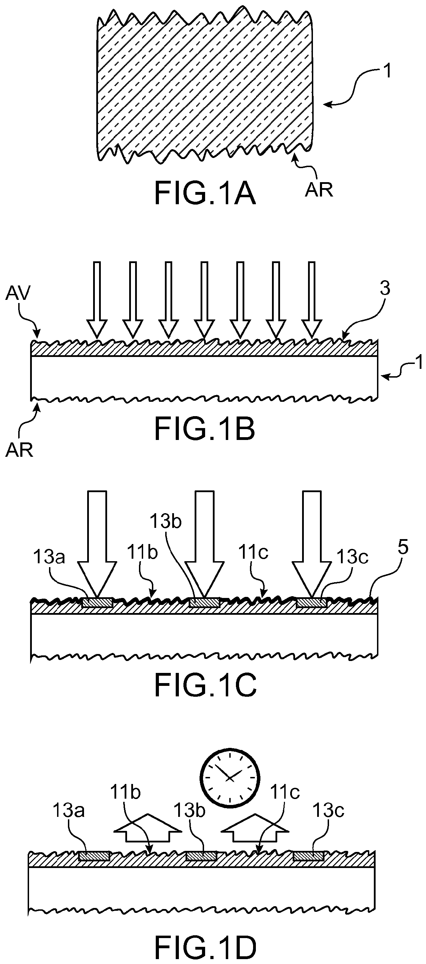

Un exemple de procédé de réalisation, dans une cellule photovoltaïque, de zones dopées adjacentes avec des concentrations et/ou profils différents va à présent être décrit en liaison avec les figures 1A-1E.

On réalise ici des zones dopées de type N, autrement dit avec un dopage qui consiste à produire un excès d'électrons.

Le matériau de départ de ce procédé peut être un substrat 1 à base de matériau semi-conducteur cristallin typiquement en silicium qui peut être monocristallin, multi-cristallin ou polycristallin. Le substrat 1 de départ peut être déjà dopé selon un dopage de type N ou P.

Afin de diminuer la réflectivité de la surface de la cellule et d'augmenter le chemin optique de la lumière dans la cellule, une texturation d'au moins une face du substrat 1 peut être prévue. Cette opération permet de former en surface un relief, par exemple sous forme de motifs pyramidaux micrométriques. La texturation est typiquement réalisée par action mécanique ou par attaque chimique, par exemple en plaçant le substrat 1 dans un bain contenant une solution de KOH.

Dans l'exemple de réalisation illustré sur la figure 1A, une texturation du substrat 1 est mise en œuvre aussi bien au niveau de sa face avant AV que de sa face arrière AR. Par « face avant » on entend, dans cet exemple, une face principale du substrat 1 qui est destinée à être directement exposée au soleil, tandis que la « face arrière » est la face principale opposée à la face avant.

La figure 1B illustre une étape ultérieure de dopage d'une zone 3 du substrat 1 qui s'étend le long d'une première face AV de ses faces principales AV, AR. Le dopage de la première face ou face avant AV est ici réalisé par implantation.

De manière avantageuse, ce dopage est effectué par implantation par immersion plasma (PIII pour « Plasma Immersion Ion Implantation »). Cette technique, qui utilise un plasma comme source d'espèce dopante, permet notamment de réaliser un dopage à coût réduit. Dans cet exemple de réalisation, le dopage de type N de la première face est effectué au moyen de Phosphore. L'implantation peut être dans ce cas effectuée en présence d'un précurseur gazeux de type phosphine PH₃.

L'implantation par immersion plasma conduit à un profil de concentration en dopants maximale au niveau de la surface. Elle permet ainsi d'obtenir une très forte concentration en dopants au niveau de la surface après implantation. Les concentrations en dopants au niveau de la surface après implantation peuvent être supérieures à 1x10²⁰ at/cm³. La profondeur de la zone 3 implantée avec cette technique peut être comprise par exemple entre 10 nm et 150 nm.

L'implantation est typiquement prévue avec une dose par exemple comprise entre 5x10¹⁴ at/cm² et 2x10¹⁶ at/cm² et une tension d'accélération comprise par exemple entre 100V et 10 kV. Avantageusement, on réalise une implantation, avec une tension d'accélération qui est inférieure à 15kV, de préférence inférieure à 10kV et avec une dose d'implantation au moins supérieure à 1E15 at/cm², et de préférence entre 2E15 à 5E15 at/cm². La dose est ici donnée dans le cas d'une implantation PIII à partir de précurseur PH₃, celle-ci comprenant à la fois les ions du plasma contenant du Phosphore et les ions hydrogène. La zone 3 implantée peut être au moins partiellement rendue amorphe.

Une fois l'implantation réalisée, un phénomène de désorption de l'espèce dopante implantée peut avoir lieu. En particulier, le Phosphore implanté peut désorber et réagir avec l'oxygène environnant pour former une couche 5 d'oxyde de Phosphore, en particulier de type P₂O₅. Une telle couche 5 d'oxyde de Phosphore a une épaisseur de plusieurs nm et par exemple de l'ordre de 3nm.

Cette désorption pourrait d'ordinaire constituer un désavantage dans la mesure où elle pourrait nécessiter l'implantation d'une dose plus forte pour la compenser afin de pouvoir obtenir une résistance carré spécifique.

Selon une particularité de l'invention, on cherche à éviter ou à limiter le phénomène de désorption de Phosphore au niveau d'au moins une région donnée localisée de la première face AV, tout en utilisant ce phénomène de désorption au niveau d'au moins une portion de cette première face AV.

Pour cela, on effectue ensuite de manière localisée, comme sur la figure 1C, un recuit de recristallisation par traitement laser d'au moins une région de la zone dopée 3. Dans l'exemple de réalisation de la figure 1C une telle étape d'exposition localisée est mise en œuvre sur des régions 13a, 13b, 13c de la zone 3 dopée situées au niveau la face avant AV. D'autres portions 11b, 11c de la face avant AV ne sont quant à elles pas exposées.

Le traitement laser localisé permet de modifier l'état de surface des régions 13a, 13b, 13c en particulier en agissant sur la couche 5 d'oxyde de Phosphore en regard des régions 13a, 13b, 13c et en recristallisant au moins partiellement et de manière localisée les régions 13a, 13b, 13c. Le recuit de recristallisation est typiquement effectué à une température inférieure à 700°C de sorte de préférence à ne faire diffuser les dopants en profondeur et en tout cas au-delà de la zone recristallisée. D'autre part, à une telle température de recuit, la limite de fusion du silicium n'est par ailleurs pas atteinte ce qui permet par ailleurs de préserver la zone texturée, par exemple sous forme de pyramides.

Les conditions laser optimales pour ce recuit dépendent du laser utilisé et de l'étape d'implantation précédemment réalisée. Dans le cas d'une implantation PIII avec précurseur PH₃ mise en œuvre avec une tension d'accélération de 4kV, un laser de longueur d'onde 355nm avec une durée d'impulsion de 15ps et une cadence de 80 MHz peut être utilisé pour effectuer la recristallisation localisée. La puissance moyenne optimale du laser est choisie de sorte à se situer sous le seuil au-delà duquel une fusion du silicium peut se produire. Par exemple, dans les conditions évoquées précédemment, ce seuil peut être de l'ordre de 3,3W.

Un protocole pour trouver des conditions de puissance du laser à utiliser pour la recristallisation peut être le suivant :
Après une implantation PIII évoquée précédemment :
- on effectue un recuit laser de recristallisation directement après implantation à différentes puissances sur un premier ensemble de substrats et on réaliser un recuit thermique d'activation directement après implantation sur un deuxième ensemble de substrats ; puis
- on soumet le premier ensemble à un temps d'attente d'au moins 24h après le recuit laser et dès lors que ce temps d'attente est écoulé on réalise le recuit thermique d'activation sur ce premier ensemble de substrats,
- on mesure la résistance carré R² après recuit sur les substrats du premier ensemble et du deuxième ensemble, afin de remonter à une valeur de puissance ou de gamme de puissances laser qui permet d'obtenir une résistance carré R² équivalente entre un substrat du premier ensemble ayant subi le recuit laser de recristallisation directement après implantation et sans temps d'attente et un substrat du deuxième ensemble qui a été soumis au temps d'attente. Par résistance carré R² équivalente, on entend une résistance qui varie de moins de 5 ohm/sq ou 3 ohm/sq.

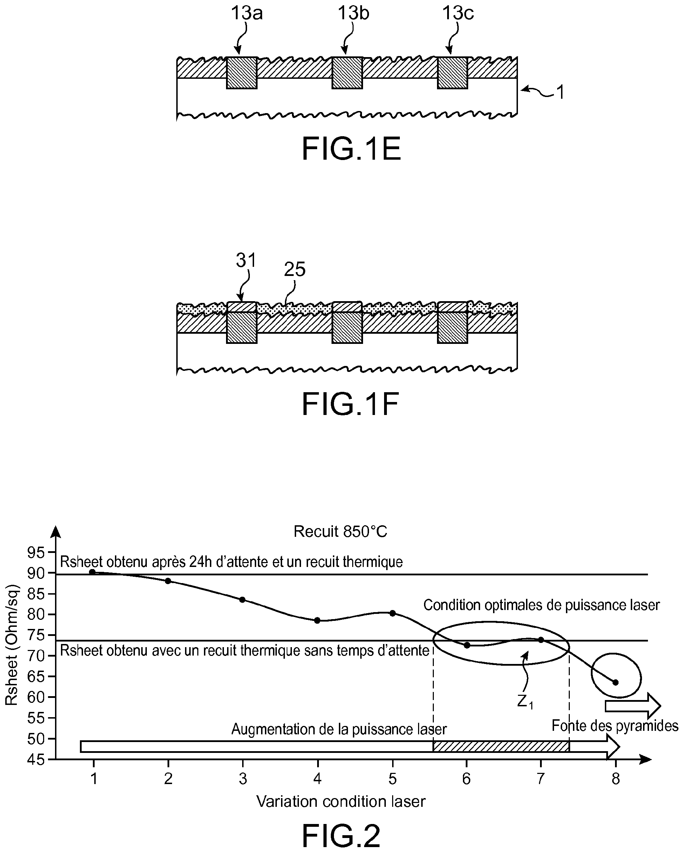

La figure 2 sert à illustrer un tel protocole dans un cas particulier par exemple où le recuit d'activation est réalisé à 850°C, tandis que le temps d'attente est de 24 h. Les conditions optimales de puissance laser sont représentées par une zone hachurée, correspondant à un ensemble de points de mesure délimités par une zone notée Z₁.

Comme suggéré précédemment, le traitement laser d'une ou plusieurs régions 13b, de la zone dopée 3 peut être effectué au moyen d'un faisceau laser localisé sur cette région 13b, tandis que d'autre portions 11b, 11c disposées autour de la région 13b ne sont quant à elles pas exposées à un faisceau laser.

La recristallisation par exposition localisée au laser est mise en œuvre sur les régions 13a, 13b, 13c de la face AV du substrat 1 au niveau desquelles on souhaite limiter ou stopper un phénomène de désorption de dopants.

Les autres portions 11b, 11c de la face AV adjacentes des régions 13a, 13b, et qui n'ont pas été pas exposées au laser correspondent quant à elles à des zones pour lesquelles on souhaite favoriser le phénomène de désorption de dopants.

On prévoit ensuite un temps d'attente d'une durée prédéterminée entre l'étape de recristallisation au laser et une étape ultérieure de traitement thermique en vue cette fois d'activer l'ensemble des dopants restants. Pour cela, on peut conserver le substrat 1 à l'air ou bien sous une atmosphère contrôlée, typiquement contenant du N₂, et de préférence de l'oxygène. Durant une telle étape d'attente, le phénomène de désorption de dopants se prolonge au niveau des portions 11b, 11c non exposées. Leur concentration en dopants diminue durant ce temps d'attente. Dans le même temps, le phénomène de désorption est atténué voire empêché dans les régions 13a, 13b, 13c de par le traitement laser localisé de recristallisation effectué précédemment.

La durée est choisie en fonction de l'écart de concentration en dopants requise ou de l'écart de résistance carré souhaité entre d'une part les portions 11b, 11c et d'autre part les régions 13a, 13b, 13c. On adapte le temps d'attente afin d'obtenir un écart de résistance carré significatif et d'au moins 5 ohm/sq. La durée d'attente peut être prévue entre 1h et 1 semaine. De préférence, cette durée est supérieure à 5h et avantageusement de l'ordre de 24h ou supérieure.

Ensuite, on procède à au moins un recuit thermique prévu à une température et selon une durée adaptées de sorte à réaliser une activation des dopants phosphore de la zone implantée, et en particulier des régions 13a, 13b, 13c et portions 11b, 11c. Les portions 11b, 11c et régions 13a, 13b, 13c subissent cette fois le même traitement lord du recuit d'activation. Ainsi, avec ce recuit d'activation, les dopants, qui varient en quantités entre les portions 11b, 11c et régions 13a, 13b, 13c, sont activés. De préférence le recuit est choisi afin d'activer la totalité des dopants présents et diffusent en profondeur en fonction du budget thermique utilisé. De même le budget thermique est choisi de préférence en fonction de la profondeur de jonction souhaitée, qui est typiquement la même pour les portions 11b, 11c et régions 13a, 13b, 13c.

Le recuit d'activation est typiquement réalisé à une température supérieure à 780°C et qui peut être comprise par exemple entre 780°C et 1100°C et selon une durée prévue par exemple entre 1 min et 120 min. De préférence, le recuit d'activation est réalisé à une température comprise entre 800°C et 950°C. On évite ici en particulier un recuit susceptible de détériorer l'épaisseur superficielle de la face avant AV, et en particulier la zone texturée lorsque le substrat 1 comporte une telle zone.

Différents profils de recuits peuvent être mis en œuvre. On peut par exemple effectuer un recuit de type « classique», c'est à dire ayant un profil avec une montée en température lente, par exemple de l'ordre de 10°C/min et un maintien en température pendant une durée d'au moins une dizaine de minutes. Un autre exemple de réalisation prévoit d'utiliser un recuit de type « spike », autrement dit avec un profil de température en forme de pic c'est à dire avec une montée en température rapide, par exemple de l'ordre de plusieurs secondes tout de suite suivie d'une baisse de température rapide et de l'ordre de plusieurs secondes.

À l'issue du recuit d'activation (figure 1E), on obtient des régions 13a, 13b, 13c fortement dopées, par exemple dopées N++ avec une concentration en dopants qui peut être comprise entre 1x10²⁰ at/cm³ et 5x10²⁰ at/cm³, et des portions 11b, 11c moins dopées que les régions 13a, 13b, 13c, et en particulier dopée N+. Les portions 11b, 11c plus faiblement dopées, peuvent avoir une concentration de dopants comprise entre 8x10¹⁹ at/cm³ et 3x10²⁰ at/cm³.

Les profils de dopage différents obtenus à l'issue du recuit d'activation entre d'une part la ou les portions 11b, 11c n'ayant pas subi le traitement laser de recristallisation et d'autre part la ou les autres région(s) 13a, 13b, 13c ayant été soumis(es) à ce traitement peuvent être mesurés par une technique de profilage électrochimique de capacité-tension ECV (acronyme de « Electrochemical Capacitance-Voltage ») permettant d'obtenir un profil de concentration de porteurs actifs dans la couche semi-conductrice du substrat 1, ou bien par une technique de type SIMS (pour « Secondary Ion Mass Spectrometry »). Les niveaux de dopage respectifs sont également quantifiables par le biais d'une mesure électrique de type 4 pointes.

Pour des conditions de recuit d'activation à une température de l'ordre de 850°C (N2) avec oxydation, une mesure 4 pointes a montré qu'une durée d'attente de l'ordre d'un jour peut permettre une augmentation de résistance carré par exemple de l'ordre de 12 Ohm/sq pour les portions 11b, 11c subissant la désorption du phosphore. La désorption étant plus importante le premier jour que par la suite, on peut prévoir de limiter la durée d'attente prédéterminée par exemple à 1 semaine. Une augmentation de résistance carré de l'ordre de 5 Ohm/sq avec le même temps d'attente apparait également pour un recuit d'activation sous N2 à une température de l'ordre de 1050°C.

Les régions 13a, 13b, 13c qui ont subi le traitement de recristallisation localisé présentent un dopage plus conséquent et peuvent être ainsi prévues pour réaliser une prise de contact(s).

On peut ensuite former sur la première face AV du substrat 1 une couche 25 à base d'un matériau, de préférence diélectrique, et d'épaisseur prévus de manière à servir d'anti-reflet. La couche antireflet 25, par exemple en SiNx, permet de réduire les pertes optiques liées aux réflexions du rayonnement lumineux et d'optimiser l'absorption du rayonnement lumineux par le substrat 1. De manière optionnelle, une couche antireflet 25 en SiNₓ, peut être également utilisée comme couche dédiée à la passivation.

Puis (figure 1F), on forme au moins une électrode 31 métallique sur la première face AV, et en particulier en contact avec les régions 13a, 13b, 13c, dans cet exemple dopée N++. Typiquement, cette étape comporte une métallisation qui peut être réalisée par exemple par sérigraphie.

L'électrode 31 peut être formée par le dépôt par sérigraphie d'une pâte métallique par exemple à base d'Argent suivit d'un recuit du contact. Le dépôt métallique et les régions 13a, 13b, 13c sur laquelle il est réalisé peut prendre la forme d'une grille. Le recuit du contact peut se faire par exemple dans un four à lampe infra-rouge et peut permettre à la pâte à base d'Argent de traverser la couche antireflet 25.

Le procédé qui a été décrit précédemment s'applique à la fabrication de cellules solaires incluant un dopage sélectif au phosphore, pouvant être présent dans les cellules en silicium dotées d'un champ de surface arrière BSF (Back Surface Field) réalisé par un dépôt d'aluminium, cellule de type Al-BSF, les cellules de type PERC (« Passivated Emitter and Rear Cell » ou « Passivated Emitter and Rear Contact ») ou de type PERT (« Passivated Emitter, Rear Totally diffused »).

Un tel procédé peut toutefois être également employé afin de réaliser des zones de dopages et/ou profils différents, en particulier des zones adjacentes N++ et N+ dans un autre type de dispositif, et par exemple dans un dispositif microélectronique ou optoélectronique.

## Revendications

1. Procédé de réalisation d'une structure semi-conductrice pour cellule solaire avec des régions dopées N ayant des profils et/ou des concentrations en dopants différentes, comprenant les étapes suivantes :
- implanter une espèce dopante, en particulier du Phosphore, dans une zone superficielle d'un substrat (1) semi-conducteur,
- effectuer un recuit thermique de recristallisation localisé à une température de préférence inférieure à 700°C, le recuit thermique de recristallisation localisé étant réalisé à l'aide d'un laser en exposant une ou plusieurs premières régions de la zone superficielle tandis que des portions (11b, 11c) de la zone superficielle ne sont pas exposées au laser, puis
- conserver le substrat (1) pendant un temps d'attente prédéterminé supérieur à 1 h de préférence supérieur à 5 h et avantageusement égal ou supérieur à 24h, puis,
- effectuer un recuit d'activation des dopants des premières régions (13a, 13b, 13c) et desdites portions par traitement thermique de l'ensemble des premières régions et desdites portions (11b, 11c).

2. Procédé selon la revendication 1, dans lequel la zone superficielle comporte au moins une face texturée avec des motifs en relief, en particulier des motifs pyramidaux ou formant une surface dentelée.

3. Procédé selon l'une des revendications 1 ou 2, dans lequel le substrat est conservé durant ledit temps d'attente sous atmosphère comprenant de l'oxygène.

4. Procédé selon l'une des revendications 1 à 3, dans lequel le recuit d'activation des dopants des premières régions (13a, 13b, 13c) et desdites portions est réalisé à une température comprise entre 780°C et 1100°C, de préférence entre 800°C et 950°C.

5. Procédé selon l'une des revendications 1 à 4, dans lequel l'implantation de ladite espèce dopante est réalisée par immersion plasma (PIII), en particulier à l'aide d'un précurseur gazeux à base de PH₃.

6. Procédé selon l'une des revendications 1 à 5, dans lequel à l'issue dudit recuit d'activation, lesdites une ou plusieurs premières régions sont dopées N++, lesdites une ou plusieurs portions sont dopées N+.

7. Procédé selon l'une des revendications 1 à 6, dans lequel à l'issue dudit recuit d'activation, la différence entre la résistance carré desdites une ou plusieurs premières régions (13a, 13b, 13c) et desdites portions (11b, 11c) est d'au moins 5 ohm/carré.

8. Procédé de réalisation d'une cellule solaire comprenant :
- la mise en œuvre d'une structure suivant un procédé selon l'une des revendications 1 à 7, puis,
- la formation d'un ou plusieurs contacts (31) respectivement sur lesdites une ou plusieurs premières régions (13a, 13b, 13c).

## Patentansprüche

1. Verfahren zur Herstellung einer Halbleiterstruktur für Solarzellen mit N-dotierten Bereichen mit unterschiedlichen Profilen und/oder Dotierstoffkonzentrationen, umfassend die folgenden Schritte:
- Implantieren einer Dotierungsspezies, insbesondere Phosphor, in eine Oberflächenzone eines Halbleitersubstrats (1),
- Durchführen eines lokalisierten thermischen Rekristallisationsglühens bei einer Temperatur von vorzugsweise weniger als 700°C, wobei das lokalisierte thermische Rekristallisationsglühen mit Hilfe eines Lasers durchgeführt wird, indem ein oder mehrere erste Bereiche der Oberflächenzone belichtet werden, während Abschnitte (11b, 11c) der Oberflächenzone nicht dem Laser ausgesetzt werden, dann
- Halten des Substrats (1) für eine vorbestimmte Wartezeit von mehr als 1 Stunde, vorzugsweise mehr als 5 Stunden und vorteilhafterweise gleich oder mehr als 24 Stunden, dann,
- Durchführen eines Aktivierungsglühens der Dotierstoffe der ersten Bereiche (13a, 13b, 13c) und der Abschnitte durch Wärmebehandlung aller ersten Bereiche und Abschnitte (11b, 11c).

2. Verfahren nach Anspruch 1, wobei die Oberflächenzone zumindest eine texturierte Fläche mit Reliefmustern, insbesondere Pyramidenmustern, aufweist oder eine gezackte Oberfläche bildet.

3. Verfahren nach einem der Ansprüche 1 oder 2, wobei das Substrat während der Wartezeit in einer Sauerstoff enthaltenden Atmosphäre gehalten wird.

4. Verfahren nach einem der Ansprüche 1 bis 3, wobei das Aktivierungsglühen der Dotierstoffe der ersten Bereiche (13a, 13b, 13c) und der Abschnitte bei einer Temperatur zwischen 780°C und 1100°C, vorzugsweise zwischen 800°C und 950°C, durchgeführt wird.

5. Verfahren nach einem der Ansprüche 1 bis 4, wobei die Implantation der Dotierspezies durch Plasmaimmersion (PIII) erfolgt, insbesondere unter Verwendung eines gasförmigen Vorläufers auf PH₃-Basis.

6. Verfahren nach einem der Ansprüche 1 bis 5, wobei nach Abschluss des Aktivierungsglühens der eine oder die mehreren ersten Bereiche N++ dotiert sind und der eine oder die mehreren Abschnitte N+ dotiert sind.

7. Verfahren nach einem der Ansprüche 1 bis 6, wobei nach Abschluss des Aktivierungsglühens die Differenz zwischen dem quadratischen Widerstand des einen oder der mehreren ersten Bereiche (13a, 13b, 13c) und der Abschnitte (11b, 11c) mindestens 5 Ohm/Quadrat beträgt.

8. Verfahren zur Herstellung einer Solarzelle, umfassend:
- Bereitstellen einer Struktur gemäß einem Verfahren nach einem der Ansprüche 1 bis 7, dann
- Bilden eines oder mehrerer Kontakte (31) jeweils auf dem einen oder den mehreren ersten Bereichen (13a, 13b, 13c).

## Claims

1. A method for making a semi-conducting structure for a solar cell with N-doped regions having profiles and/or different dopant concentrations, comprising the following steps of:
- implanting a doping species, in particular phosphorous, in a surface zone of a semiconductor substrate (1),
- performing a localised recrystallization thermal annealing at a temperature preferably lower than 700°C, the localised recrystallization thermal annealing being carried out using a laser by exposing one or more first regions of the surface zone whereas portions (11b, 11c) of the surface zone are not exposed to the laser, and then
- keeping the substrate (1) for a predetermined waiting time greater than 1h preferably greater than 5h and advantageously greater than or equal to 24h, and then,
- performing an annealing of activating the dopants of the first regions (13a, 13b, 13c) and said portions by thermally treating all of the first regions and said portions (11b, 11c).

2. The method according to claim 1, wherein the surface zone comprises at least one textured face with relief patterns, in particular pyramidal patterns or forming a serrated surface.

3. The method according to one of claims 1 or 2, wherein the substrate is kept for said waiting time under atmosphere comprising oxygen.

4. The method according to one of claims 1 to 3, wherein the annealing of activating the dopants of the first regions (13a, 13b, 13c) and said portions is carried out at a temperature between 780°C and 1100°C, preferably between 800°C and 950°C.

5. The method according to one of claims 1 to 4, wherein implanting said doping species is carried out by plasma immersion (PIII), in particular using a PH₃-based gas precursor.

6. The method according to one of claims 1 to 5, wherein at the end of said activation annealing, said one or more first regions are N++ doped, said one or more portions are N+ doped.

7. The method according to one of claims 1 to 6, wherein at the end of said activation annealing, the difference between the sheet-resistance of said one or more first regions (13a, 13b, 13c) and said portions (11b, 11c) is at least 5 ohm/square.

8. A method for making a solar cell comprising:
- implementing a structure according to a method according to one of claims 1 to 7, and then,
- forming one or more contacts (31) on said one or more first regions (13a, 13b, 13c) respectively.
